(19) **Europäisches Patentamt**

**European Patent Office**

**Office européen des brevets**

(11) Veröffentlichungsnummer: **0 075 720 B1**

(12) **EUROPÄISCHE PATENTSCHRIFT**

(45) Veröffentlichungstag der Patentschrift:
**11.03.87**

(21) Anmeldenummer: **82107550.4**

(22) Anmeldetag: **18.08.82**

(51) Int. Cl.⁴: **H 01 L 31/10,** H 01 L 29/743, H 01 L 29/08

(54) **Lichtzündbarer Thyristor mit steuerbaren Emitter-Kurzschlüssen und Zündverstärkung.**

(30) Priorität: **29.09.81 DE 3138763**

(43) Veröffentlichungstag der Anmeldung:
**06.04.83 Patentblatt 83/14**

(45) Bekanntmachung des Hinweises auf die Patenterteilung:
**11.03.87 Patentblatt 87/11**

(84) Benannte Vertragsstaaten:
**CH FR GB IT LI NL SE**

(56) Entgegenhaltungen:
**EP - A - 0 030 274**
**DE - A - 2 945 335**
**US - A - 4 122 480**

(73) Patentinhaber: **Siemens Aktiengesellschaft Berlin und München, Wittelsbacherplatz 2, D-8000 München 2 (DE)**

(72) Erfinder: **Stoisiek, Michael, Dr. Dipl.Phys., Robert-Koch-Strasse 24, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung bezieht sich auf einen lichtzündbaren Thyristor nach dem Oberbegriff des Anspruchs 1.

Ein Thyristor dieser Art ist aus der DE-A 2 945 335 bekannt. Zum Zünden eines solchen Thyristors ist jedoch neben einem Lichtimpuls auch ein Steuerspannungsimpuls für die MIS-Strukturen erforderlich. Um die Vorteile der Lichtzündung, nämlich eine störungssichere und hochspannungsfeste galvanische Entkopplung der Thyristoranschlüsse von einer die Steuerspannung erzeugenden Ansteuerschaltung zu erhalten, muss die Ansteuerschaltung als eine Optokoppleranordnung ausgebildet werden, was jedoch aufwendig ist.

Der Erfindung liegt die Aufgabe zugrunde, einen Thyristor der eingangs genannten Art anzugeben, bei dem die Zündung einschliesslich der während des Zündvorgangs erforderlichen Steuerung der Emitter-Kurzschlüsse in einfacher Weise von der Belichtung der Thyristorfläche abgeleitet wird. Das wird durch eine Ausbildung des Thyristors nach dem kennzeichnenden Teil des Anspruchs 1 erreicht.

Der mit der Erfindung erzielbare Vorteil liegt insbesondere darin, dass die während des blockierenden Zustands in den Gate-Kapazitäten der MIS-Strukturen gespeicherte elektrische Energie mit zur Zündung herangezogen wird und man dadurch mit einer relativ geringen Steuerleistung zum Auslösen des Zündvorganges auskommt.

Die Ansprüche 2 bis 4 betreffen vorteilhafte Ausgestaltungen und Weiterbildungen der Erfindung.

Die Erfindung wird nachfolgend anhand der Zeichnung näher erläutert. Dabei zeigt:

Fig. 1 ein bevorzugtes Ausführungsbeispiel des Thyristors nach der Erfindung, und

Fig. 2 ein Ersatzschaltbild der Anordnung nach Fig. 1.

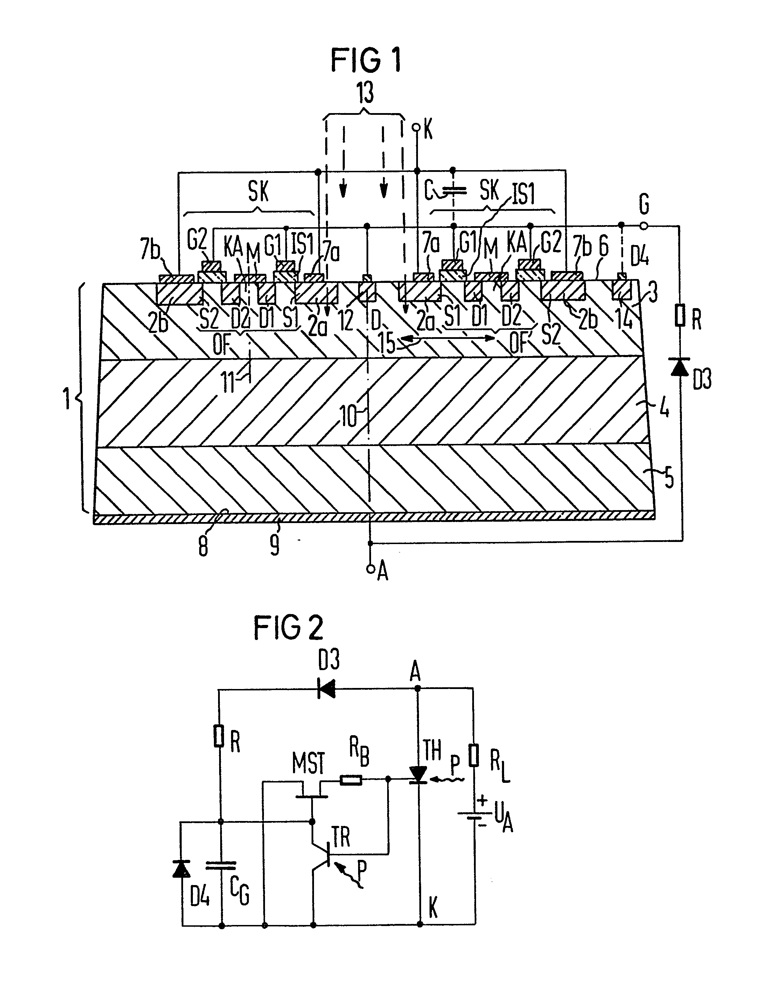

In Fig. 1 ist ein nach der Erfindung ausgebildeter Thyristor dargestellt. Er weist einen Körper 1 aus monokristallinem Halbleitermaterial, z. B. Silizium, auf, der n-leitende Schichten 2a, 2b und 4 und p-leitende Schichten 3 und 5 enthält. Die aus zwei Teilen 2a und 2b bestehende Schicht wird auch als n-Emitter bezeichnet, die Schicht 3 als p-Basis, die Schicht 4 als n-Basis und die Schicht 5 als p-Emitter. Die Teile 2a und 2b des n-Emitters sind an der Grenzfläche 6 des Halbleiterkörpers 1 mit Belegungen 7a und 7b aus elektrisch leitendem Material, z. B. Aluminium, versehen, die zusammen die Kathode des Thyristors bilden. Sie sind mit einem Anschluss K verbunden. Der p-Emitter 5 wird in der gegenüberliegenden Grenzfläche 8 des Halbleiterkörpers von einer Anode 9 aus elektrisch leitendem Material, z. B. Aluminium, kontaktiert. Die Anode 8 ist mit einem Anschluss A versehen.

Der n-Emitter 2a, 2b ist in Fig. 1 mit steuerbaren Emitter-Kurzschlüssen SK versehen, die jeweils aus einem MIS-Feldeffekttransistor, z. B. S1, D1, G1 oder S2, D2, G2, einem sich bis zur Grenzfläche 6 erstreckenden Ansatz KA der p-Basis 3 und einer auf der Grenzfläche 6 plazierten Metallisierungsbrücke M bestehen. Der randseitige Bereich des n-Emitterteils 2a, der mit S1 bezeichnet ist, stellt dabei ein Sourcegebiet dar. Ein Draingebiet D1, das $n^+$-dotiert ist, und ein durch eine dünne elektrisch isolierende Schicht IS1 von 6 getrenntes Gate G1 aus leitendem Material, das mit einem Anschluss G beschaltet ist, ergänzen S1 zu einem MIS-Transistor, der im leitenden Zustand eine niederohmige Verbindung von dem Ansatz KA über M zum n-Emitterteil 2a herstellt. In analoger Weise bilden die Teile S2, D2 und G2 einen zweiten MIS-Transistor, der im leitenden Zustand eine niederohmige Verbindung zwischen KA und dem Teil 2b des n-Emitters herstellt. Die Metallisierungsbrücke M verbindet dabei den Ansatz KA mit den Draingebieten D1 und D2.

Ist die Thyristoranordnung nach Fig. 1 einschliesslich der steuerbaren Emitterkurzschlüsse SK zu einer Achse 10 kreissymmetrisch ausgebildet, so liegen die MIS-Strukturen jeweils am äusseren Rand eines kreisringförmigen n-Emitterteils 2a und am inneren Rand eines kreisringförmigen n-Emitterteils 2b. In Weiterbildung dieser Ausführungsform können selbstverständlich auch mehrere solcher MIS-Strukturen eine Mehrzahl von kreisringförmigen, konzentrischen n-Emitterteilen jeweils voneinander trennen. Die n-Emitterteile 2a, 2b können aber auch streifenförmig ausgebildet sein und von streifenförmigen MIS-Strukturen flankiert sein (Fingerstruktur). Ferner kann die Anordnung nach Fig. 1 auch so ausgebildet sein, dass anstelle der voneinander getrennten n-Emitterteile 2a und 2b ein in sich geschlossener n-Emitter 2a, 2b vorgesehen ist, der mit einer Mehrzahl von möglichst gleichmässig verteilten Öffnungen OF und OF' versehen ist. In diesem Fall deuten die Bezugszeichen D1 und D2 lediglich verschiedene Schnittflächen ein und desselben kreisringförmigen $n^+$-dotierten Draingebiets an, das zu einer Achse 11 zentrisch symmetrisch ausgebildet ist. S1 und S2 bedeuten dann unterschiedliche Schnittflächen ein und derselben, die Öffnung OF umgebenden Randzone des n-Emitters 2a, 2b. Die Ansteuerung und die prinzipielle Wirkungsweise der steuerbaren Emitterkurzschlüsse SK bleiben von diesen Ausführungsvarianten unbeeinflusst.

Wenn die Gatespannung, d. h. die über G zugeführte Spannung an G1 und G2 relativ zu dem darunter liegenden Teil der p-Basis 3 Null ist, sind die Feldeffekttransistoren S1, G1, D1 und S2, G2, D2 gesperrt, die Emitter-Kurzschlüsse sind ausgeschaltet und der Thyristor befindet sich im Zustand hoher Zündempfindlichkeit. Durch Anlegen einer positiven Gatespannung können die Kurzschlüsse eingeschaltet und der Thyristor in einen zündunempfindlichen und stabilen Zustand versetzt werden. Zur Steuerung der MIS-Feldeffekttransistoren ist der Steueranschluss G dieser Feldeffekttransistoren über einen hochohmigen strombegrenzenden Widerstand R und eine Diode D3 mit dem Anodenanschluss A verbunden. Zusätzlich besteht eine Verbindung von G zum Anschluss einer weiteren $n^+$-dotierten Zone 12, die sich in enger Nachbarschaft zum inneren Rand des n-Emitters 2a befindet. Der innere Rand von 2a bildet den Emitter, der Bereich 12 den Kollektor und der zwischen diesen Bereichen an die Oberfläche tretende Teil der p-Basis des Thyristors die Basis eines lichtgesteuerten npn-Lateraltransistors. Sobald nun an der Anode 9 eine positive Spannung liegt, kommt diese auch über den Widerstand R und die Diode D3 an den Steueranschluss G und führt dazu, dass der Thyristor in einen zündunempfindlichen Zustand versetzt wird. Die Spannung an den Kapazitäten der Gates G1 und G2 kann dabei höchstens so gross wie die Durchbruchspannung des pn-Übergangs zwischen dem Gebiet 12 und der p-Basis 3 werden, d.h. etwa 10 bis 20 V.

Wird der Thyristor zum Einleiten einer Zündung mit Licht bestrahlt, was in Fig. 1 mit 13 angedeutet ist, so dringt ein grosser Teil des Lichtes durch den bestrahlten n-Emitterbereich bis zur Raumladungszone des pn-Überganges zwischen den Schichten 3 und 4 vor und führt dort in bekannter Weise zur Entstehung eines Photostromes, der als Zündstrom des Thyristors dient. Gleichzeitig wird der Basisbereich des npn-Lateraltransistors bestrahlt, was ein Durchschalten dieses Transistors und ein Entladen der Gatekapazitäten der MIS-Transistoren bewirkt. Die MIS-Transistoren werden dadurch gesperrt und der Thyristor in einen zündempfindlichen Zustand versetzt. Wegen der relativ grossen Gatekapazitäten der MIS-Transistoren fliesst dabei ein kräftiger, als zusätzlicher Zündstromstoss wirkender Entladestrom in die p-Basis 3. Durch Parallelschalten eines externen Kondensators C zur MOS-Kapazität kann dieser zusätzliche Zündstromstoss noch vergrössert werden.

Die Einsatzspannung der MIS-Transistoren sollte so klein sein, dass die nach dem Zünden an der Anode 9 anliegende Durchlassspannung ausreicht, die Emitterkurzschlüsse wieder wirksam zu schalten. Nur dann ist bei einem dem Abschalten des Thyristors folgenden wiederkehrenden schnellen Anstieg der an A liegenden, positiven Spannung der Thyristor vor dU/dt-Zündung geschützt.

Wird der Lichtstrahl 13 abgeschaltet, bevor der Thyristor voll durchgeschaltet ist, so muss verhindert werden, dass die Emitter-Kurzschlüsse sofort wirksam werden und zu einer Behinderung der lateralen Zündausbreitung führen. Dies kann geschehen, indem die Zeitkonstante des aus den MIS-Kapazitäten und dem Ladewiderstand R gebildeten RC-Gliedes grösser als die Ausbreitungszeit der Zündfront gewählt wird.

Im allgemeinen ist die im blockierenden Zustand des Thyristors an der Anode 9 anliegende Spannung wesentlich grösser als die Durchbruchspannung des npn-Transistors, was zur gewollten Zündung des Thyristors führt. Der Widerstand R muss deshalb so gross gewählt werden, dass der über D fliessende Strom so klein bleibt, dass er weder zur Zündung des Thyristors noch zur Zerstörung der Kollektor-Basis-Diode D führt.

Nach einer Weiterbildung der Erfindung wird in einem zündunempfindlichen Randbereich des Thyristors eine zweite Diode D4 vorgesehen, die ein n$^+$-dotiertes Gebiet 14 aufweist, das mit dem Anschluss G verbunden ist. Die Durchbruchspannung von D4 wird niedriger gewählt als die der Kollektor-Basis-Diode D. Damit begrenzt D4 die Gatespannung an G1 und G2. Nach einer Schaltungsvariante kann D4 auch durch eine externe Diode ersetzt sein.

Ein Ersatzschaltbild der in Fig. 1 dargestellten Anordnung ist in Abb. 2 gezeigt. Der Thyristor TH ist über einen Lastwiderstand $R_L$ mit einer Anodenspannungsquelle $U_A$ verbunden. Der MIS-Transistor MST beschreibt die zwischen der Kathode 7a, 7b und der p-Basis 3 des Thyristors zuschaltbaren Kurzschlüsse SK. $R_B$ bedeutet den Bahnwiderstand des Halbleiterkörpers vom inneren Rand des beleuchteten Emitterbereiches 2a bis zur ersten Kurzschlussstruktur, d.h. längs des Doppelpfeils 15, $C_G$ die Gatekapazität des MIS-Transistors MST, R den Ladewiderstand und D3 die Diode, über die die Kapazität $C_G$ von der Anodenspannung des Thyristors aufgeladen wird. D4 ist die integrierte oder extern zugeschaltete Diode zur Gatespannungsbegrenzung. TR beschreibt den npn-Lateraltransistor, dessen Emitter aus dem inneren Randbereich des Thyristoremitters gebildet wird. Im blockierenden Zustand des Thyristors ist die Spannung zwischen K und der Steuerelektrode so gering, dass weder im Transistor TR noch im Thyristor eine merkliche Elektroneninjektion stattfindet. Am Kollektor des Transistors TR stellt sich deshalb die Durchbruchspannung seines Kollektor-Basis-Übergangs oder die der Diode D4 ein, je nach dem welche von beiden die kleinere ist. Die Gatekapazität des MIS-Transistors MST ist auf diese Spannung aufgeladen, der MIS-Transistor MST ist daher im leitenden Zustand. Zum Zünden des Thyristors wird gleichzeitig Licht (P) in die p-Basis 3 des Thyristors und in die Basis des npn-Transistors TR eingestrahlt. TR wird stromführend und führt zur Entladung von $C_G$ über den Anschluss K. Wenn der Entladestrom von $C_G$ gross genug ist, führt er zur Zündung des Thyristors am inneren Rand 16 des beleuchteten Emitterbereiches.

Da der Entladestrom von $C_G$ um den Stromverstärkungsfaktor $\beta$ des npn-Transistors TR grösser ist als der durch die Beleuchtung generierte Photostrom, kann er bei kleiner Lichtleistung relativ gross sein, wenn nur der Stromverstärkungsfaktor $\beta$ genügend gross ist. Man hat es also bei der Erfindung mit einer integrierten Zündstromverstärkung zu tun, wobei ein Teil der Zündenergie während der Durchlass- und Blockier-Perioden von der Anodenspannungsquelle $U_A$ geliefert wird und bis zur Zündung in der Gatekapazität der MIS-Transistoren gespeichert wird.

Weiterhin können die Emitter-Kurzschlüsse SK sowie der genannte npn-Lateraltransistor in Abweichung von der obigen Beschreibung auch am p-Emitter 5 angeordnet sein. Zur Veranschaulichung dieser Schaltungsvariante kann die Fig. 1 herangezogen werden, wenn man die Leitungstypen der Halbleitergebiete durch die jeweils entgegengesetzten ersetzt, die Anschlüsse A und K miteinander vertauscht und die beschriebenen Spannungen und Ströme mit jeweils entgegengesetzter Polarität zuführt.

**Patentansprüche**

1. Lichtzündbarer Thyristor mit einem Halbleiterkörper (1), der einen von einer Kathode kontaktierten n-Emitter mit einer angrenzenden p-Basis und einen von einer Anode kontaktierten p-Emitter mit einer angrenzenden n-Basis aufweist, und mit an einer Grenzfläche (6) des Halbleiterkörpers angeordneten, über MIS-Transistoren steuerbaren Emitter-Kurzschlüssen, bei dem jeder MIS-Transistor einen Randbereich des n- bzw. p-Emitters (2a, 2b), ein in die p- bzw. n-Basis eingefügtes und mit dieser leitend verbundenes n- bzw. p-leitendes Halbleitergebiet (D1, D2) und einen von einem Gate (G1, G2) überdeckten Bereich der p- bzw. n-Basis (3) umfasst, dadurch gekennzeichnet, dass an der lichtbestrahlten Grenzfläche (6) ein Lateraltransistor vorgesehen ist, der einen Randbereich des n- bzw. p-Emitters (2a), ein weiteres, in die p- bzw. n-Basis (3) eingefügtes, n- bzw. p-leitendes Halbleitergebiet (12), das mit den Gates (G1) der MIS-Transistoren verbunden ist, und einen dazwischen liegenden Teilbereich der p- bzw. n-Basis (3) umfasst, und dass die Gates (G1) der MIS-Transistoren mit der Anode (9) verbunden sind.

2. Lichtzündbarer Thyristor nach Anspruch 1, dadurch gekennzeichnet, dass die Gates (G1) der MIS-Transistoren über die Serienschaltung eines Ladewiderstandes (R) und einer Diode (D3) mit der Anode (9) verbunden sind.

3. Thyristor nach einem der Ansprüche 1 oder 2, dadurch gekennzeichnet, dass die Gates (G1) der MIS-Transistoren über einen Kondensator (C) mit der Kathode (7a, 7b) verbunden sind.

4. Thyristor nach einem der vorhergehenden Ansprüche, dadurch gekennzeichnet, dass dem pn-Übergang zwischen der p- bzw. n-Basis (3) und dem weiteren, in die p- bzw. n-Basis (3) eingefügten, n- bzw. p-leitenden Halbleitergebiet (12) eine weitere, insbesondere in die p- bzw. n-Basis (3) integrierte Diode (3, 14) parallelgeschaltet ist.

**Claims**

1. A light-controllable thyristor, having a semiconductor body (1) which has an n-emitter contacted by a cathode, an adjacent p-base and a p-emitter contacted by an anode, an adjacent n-base, and emitter short-circuits which are arranged at a boundary surface (6) of the semiconductor body and can be controlled through MIS-transistors, where each MIS-transistor comprises an edge zone of the n- or p-emitter (2a, 2b), a n- or p-conducting semiconductor zone (D1, D2) which is inserted into the p- or n-base and is conductively connected thereto, and a zone, covered by a gate (G1, G2), of the p- or n-base (3), characterised in that, at the light-irradiated boundary surface (6), a lateral transistor is arranged which comprises an edge zone of the n- or p-emitter (2a), a further n- or p-conducting semiconductor zone (12) which is inserted into the p- or n-base (3) and is connected to the gates (G1) of the MIS-transistors, and an interposed sub-zone of the p- or n-base (3); and that the gates (G1) of the MIS-transistors are connected to the anode (9).

2. A light-controllable thyristor according to Claim 1, characterised in that the gates (G1) of the MIS-transistors are connected to the anode (9) through a load resistor (R) and a diode (D3) arranged in series.

3. A thyristor according to one of Claims 1 and 2, characterised in that the gates (G1) of the MIS-transistors are connected to the cathode (7a, 7b) through a capacitor (C).

4. A thyristor according to one of the preceding Claims, characterised in that the pn-junction between the p- or n-base (3) and the further n- or p-conducting semiconductor zone (12) which is inserted into the p- or n-base (3), is connected in parallel with a further diode (3, 14), particularly but not exclusively one which is integrated into the p- or n-base (3).

**Revendications**

1. Thyristor pouvant être amorcé par la lumière, possédant un corps semi-conducteur (1) qui présente un émetteur n mis en contact avec une cathode et voisin d'une base p, de même qu'un émetteur p mis en contact avec une anode et voisin d'une base n, et possédant des courts-circuits d'émetteur disposés à une surface limite (6) du corps semi-conducteur et pouvant être commandés par des transistors MIS, chaque transistor MIS comprenant une zone du bord de l'émetteur n ou p (2a, 2b), une région de semi-conducteur (D1, D2), de conductivité n ou p, qui est insérée dans la base p ou n et est en connexion conductrice avec elle, ainsi qu'une zone, recouverte par une grille (G1, G2), de la base p ou n (3), caractérisé en ce qu'un transistor latéral est prévu à la surface limite (6) exposée au rayonnement lumineux, transistor qui comprend une zone du bord de l'émetteur n ou p (2a), une région de semi-conducteur supplémentaire (12), de conductivité n ou p, insérée dans la base p ou n (3) et qui est reliée aux grilles (G1) des transistors MIS, et une zone partielle, située entre elles, de la base p ou n (3), et que les grilles (G1) des transistors MIS sont reliées à l'anode (9).

2. Thyristor selon la revendication 1, caractérisé en ce que les grilles (G1) des transistors MIS sont reliées à l'anode (9) à travers le montage en série d'une résistance de charge (R) et d'une diode (D3).

3. Thyristor selon la revendication 1 ou 2, caractérisé en ce que les grilles (G1) des transistors MIS sont reliées, à travers un condensateur (C), à la cathode (7a, 7b).

4. Thyristor selon une des revendications précédentes, caractérisé en ce qu'une diode supplémentaire, en particulier une diode (3, 14) intégrée dans la base p ou n (3), est montée en parallèle avec la jonction pn entre la base p ou n et la région de semi-conducteur supplémentaire (12), de conductivité n ou p, insérée dans la base p ou n (3).

# FIG 1

# FIG 2